Europäisches Patentamt

European Patent Office

Office européen des brevets

(11) Veröffentlichungsnummer: **0 343 352**
**A1**

## (12) EUROPÄISCHE PATENTANMELDUNG

(21) Anmeldenummer: 89106234.1

(22) Anmeldetag: 08.04.89

(51) Int. Cl.⁴: **G01P 3/489 , G01R 23/02**

(30) Priorität: 06.05.88 DE 3815535

(43) Veröffentlichungstag der Anmeldung:
**29.11.89 Patentblatt 89/48**

(84) Benannte Vertragsstaaten:
**CH DE FR GB IT LI SE**

(71) Anmelder: **Heidelberger Druckmaschinen
Aktiengesellschaft
Kurfürsten-Anlage 52-60 Postfach 10 29 40
D-6900 Heidelberg 1(DE)**

(72) Erfinder: **Hauck, Dieter
Höhenweg 36
D-6930 Eberbach(DE)**
Erfinder: **May, Karl-Heinz
Hansstrasse 13a
D-6806 Viernheim(DE)**
Erfinder: **Müller, Hans
Albrecht-Dürer-Strasse 15
D-6902 Sandhausen(DE)**
Erfinder: **Rehberger, Jürgen
Talstrasse 3
D-6915 Dossenheim(DE)**

(74) Vertreter: **Stoltenberg, Baldo Heinz-Herbert et
al
c/o Heidelberger Druckmaschinen AG
Kurfürsten-Anlage 52-60
D-6900 Heidelberg 1(DE)**

(54) Verfahren und Anordnung zur Messung der Drehzahl einer Maschine.

(57) Bei einem Verfahren zur Messung der Drehzahl einer Maschine, insbesondere einer Druckmaschine, bei der ein Inkrementalgeber Tachoimpulse erzeugt, werden während eines von den Tachoimpulsen abgeleiteten Zeitabschnitts Zählimpulse gezählt. Am Ende des Zeitabschnitts wird bei einem Rechner eine Programmunterbrechung ausgelöst und der Zählerstand vom Rechner gelesen.

Fig. 1

## Verfahren und Anordnung zur Messung der Drehzahl einer Maschine

Die Erfindung betrifft ein Verfahren und eine Anordnung zur Messung der Drehzahl einer Maschine, insbesondere einer Druckmaschine, bei der ein Inkrementalgeber Tachoimpulse erzeugt.

Für verschiedene Steuerungs- und Regelungsaufgaben im Zusammenhang mit einer Maschine ist eine Messung bzw. Erfassung der Drehzahl erforderlich. Insbesondere .bei Druckmaschinen hat dieses in einem sehr großen Drehzahlbereich und mit möglichst großer Genauigkeit zu erfolgen.

Das erfindungsgemäße Verfahren ist dadurch gekennzeichnet, daß während eines von den Tachoimpulsen abgeleiteten Zeitabschnitts Zählimpulse gezählt werden und daß am Ende des Zeitabschnitts bei einem Rechner eine Programmunterbrechung ausgelöst und der Zählerstand vom Rechner gelesen wird. Dabei entspricht vorzugsweise der Zeitabschnitt der Periodendauer oder einem Vielfachen der Periodendauer der Tachoimpulse.

Bei einer entsprechenden Wahl des Vielfachen kann somit die Häufigkeit der Programmunterbrechungen (Interrupts) niedrig gehalten werden.

Eine Weiterbildung des erfindungsgemäßen Verfahrens besteht darin, daß das Vielfache in Abhängigkeit von der Drehzahl mit zunehmender Drehzahl ansteigend vorgegeben wird. Damit kann die Häufigkeit der Programmunterbrechungen auch bei hohen Drehzahlen niedrig gehalten werden, so daß der Ablauf weiterer Rechenvorgänge weniger häufig gestört wird. Außerdem führt das erfindungsgemäße Verfahren zu einer Erhöhung der Meßgenauigkeit bei hohen Drehzahlen, da durch die Frequenzteilung auch dann eine genügend große Anzahl von Zählimpulsen gezählt wird.

Eine zusätzliche Anpassung an stark unterschiedliche Drehzahlen kann dadurch erreicht werden, daß die Frequenz der Zählimpulse veränderbar ist.

Eine vorteilhafte Anordnung zur Durchführung des erfindungsgemäßen Verfahrens ist dadurch gekennzeichnet, daß die Tachoimpulse über einen steuerbaren Frequenzteiler einer Zählerschaltung zuführbar sind, daß die Zählerschaltung mit einer Schaltung zur Erzeugung von Zählimpulsen verbunden ist, und daß Ausgänge der Zählerschaltung mit Eingängen eines Rechners verbunden sind.

Durch die in den Unteransprüchen aufgeführten Maßnahmen sind vorteilhafte Weiterbildungen und Verbesserungen der im Hauptanspruch angegebenen Erfindung möglich.

Ausführungsbeispiele der Erfindung sind in der Zeichnung anhand mehrerer Figuren dargestellt und in der nachfolgenden Beschreibung näher erläutert. Es zeigt:

Fig. 1 eine Anordnung zur Auswertung von Tachosignalen mit einem Ausführungsbeispiel der erfindungsgemäßen Anordnung,

Fig. 2 eine bei der Anordnung nach Fig. 1 verwendete Zählerschaltung,

Fig. 3 eine weitere Zählerschaltung,

Fig. 4 ein Schaltnetz, das Teil der Schaltungen nach den Figuren 2 und 3 ist,

Fig. 5 Zeitdiagramme einiger bei der Anordnung nach Fig. 2 verwendeter Signale.

Fig. 6 einen Automatengraphen zur Erläuterung der Funktion des Schaltnetzes,

Fig. 7 ein weiteres Schaltnetz,

Fig. 8 Zeitdiagramme zur Erläuterung der Drehzahlmessung und

Fig. 9 ein Flußdiagramm eines Teils des Rechnerprogramms für die Drehzahlmessung.

Gleiche Teile sind in den Figuren mit gleichen Bezugszeichen versehen.

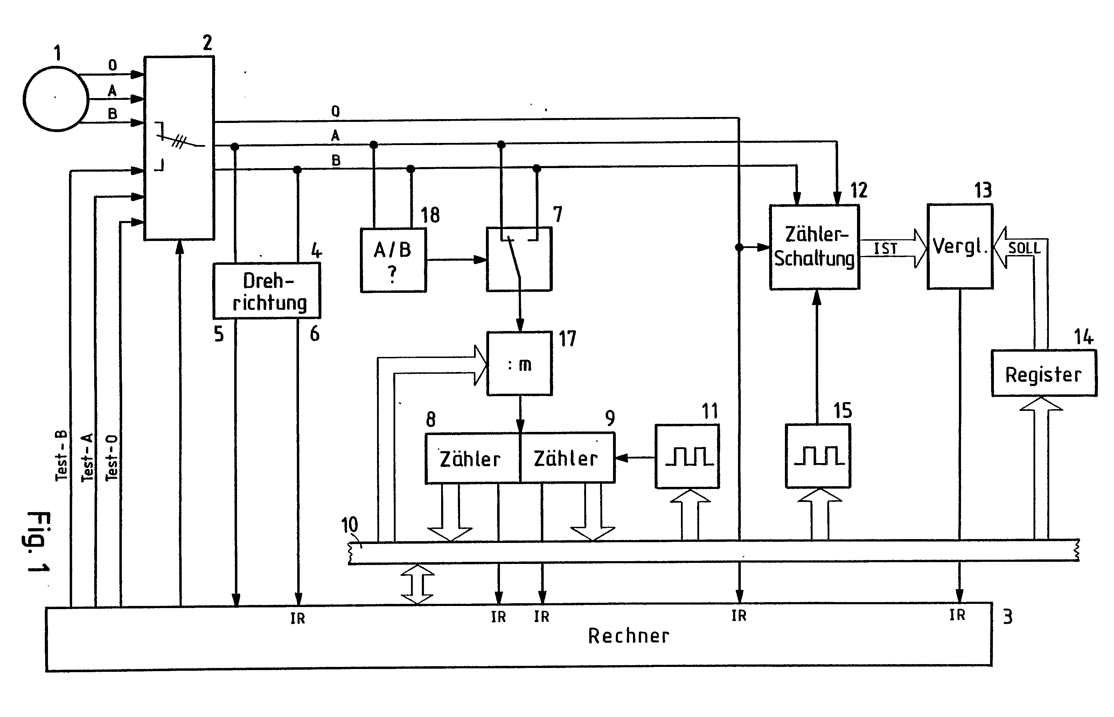

Bei der Anordnung nach Fig. 1 ist ein an sich bekannter Inkrementalgeber 1 vorgesehen. Derartige Inkrementalgeber bestehen beispielsweise aus einer mit optischen Markierungen versehenen Teilscheibe, die von opto-elektrischen Wandlern abgetastet wird. Dabei gibt einer der opto-elektrischen Wandler während einer Umdrehung einen Impuls 0 ab. Ferner werden Tachosignale A und B erzeugt, die mäanderförmig und zueinander um 90° phasenverschoben sind. Bei einem gebräuchlichen Inkrementalgeber umfassen die Tachosignale A und B jeweils 1024 Impulse pro Umdrehung.

Die Tachosignale 0, A und B werden Eingängen eines Umschalters 2 zugeführt, dessen weitere Eingänge mit elektronisch erzeugten Testsignalen Test-0, Test-A und Test-B beaufschlagt sind. Der Umschalter ist vom Rechner 3 steuerbar, so daß in einer Test-Betriebsart die im folgenden beschriebenen Schaltungen auch im Stillstand der Maschine getestet werden können.

Die Tachosignale A und B werden zur Erfassung der Drehrichtung und der Position sowie zur Messung der Geschwindigkeit bzw. Drehzahl ausgewertet. Zur Erfassung der Drehrichtung werden die Tachosignale A und B einer Schaltung 4 zugeführt. Die Schaltung 4 weist zwei Ausgänge 5, 6 auf, wobei am Ausgang 5 ein Signal zur Kennzeichnung der Drehrichtung ansteht und am Ausgang 6 ein Impuls bei Änderung der Drehrichtung abgegeben wird. Während das die Drehrichtung kennzeichnende Signal einem Dateneingang des Rechners zugeführt wird, erzeugt der Impuls am Ausgang 6 eine Programmunterbrechung (Interrupt, IR).

Die Messung der Drehzahl erfolgt mit zwei Zählern 8, 9, denen über einen Umschalter 7 und einen Frequenzteiler 17 eines der Tachosignale A bzw. B zugeführt wird. Dabei wird der Umschalter 7 von einer Schaltung 18 derart gesteuert, daß bei Ausfall eines der Tachosignale das andere weitergeleitet wird. Der Frequenzteiler 17 ist programmierbar, wozu das jeweilige Teilerverhältnis über den Datenbus 10 vom Rechner 3 zugeführt wird. Den Zählern 8, 9 wird ein Referenzsignal zugeführt, dessen Frequenz entsprechend der Auflösung der Drehzahlmessung wesentlich höher als die Frequenz der Tachosignale ist. Um auch bei hohen Drehzahlen eine hohe Auflösung der Drehzahlmessung zu erreichen, ohne daß bei niedrigen Drehzahlen die Zähler 8, 9 überlaufen, kann die Frequenz des Referenzsignals variiert werden. Dazu wird ein entsprechender Wert über das Bussystem 10 dem Oszillator 11 für das Referenzsignal zugeführt.

Die Messung der Drehzahl erfolgt nun derart, daß abwechselnd einer der Zähler zwischen zwei vom Frequenzteiler 17 abgegebenen Impulsen die Impulse des Referenzsignals zählt. Nach Beendigung des Zählvorganges wird eine Programmunterbrechung (IR) ausgelöst, worauf der Rechner den Zählerstand über den Datenbus 10 liest. Inzwischen wurde bereits der andere Zähler gestartet, so daß die Dauer einer jeden Periode der Ausgangssignale des Frequenzteilers 17 gemessen wird. Die Meßwerte werden im Rechner 3 in Drehzahlwerte umgerechnet.

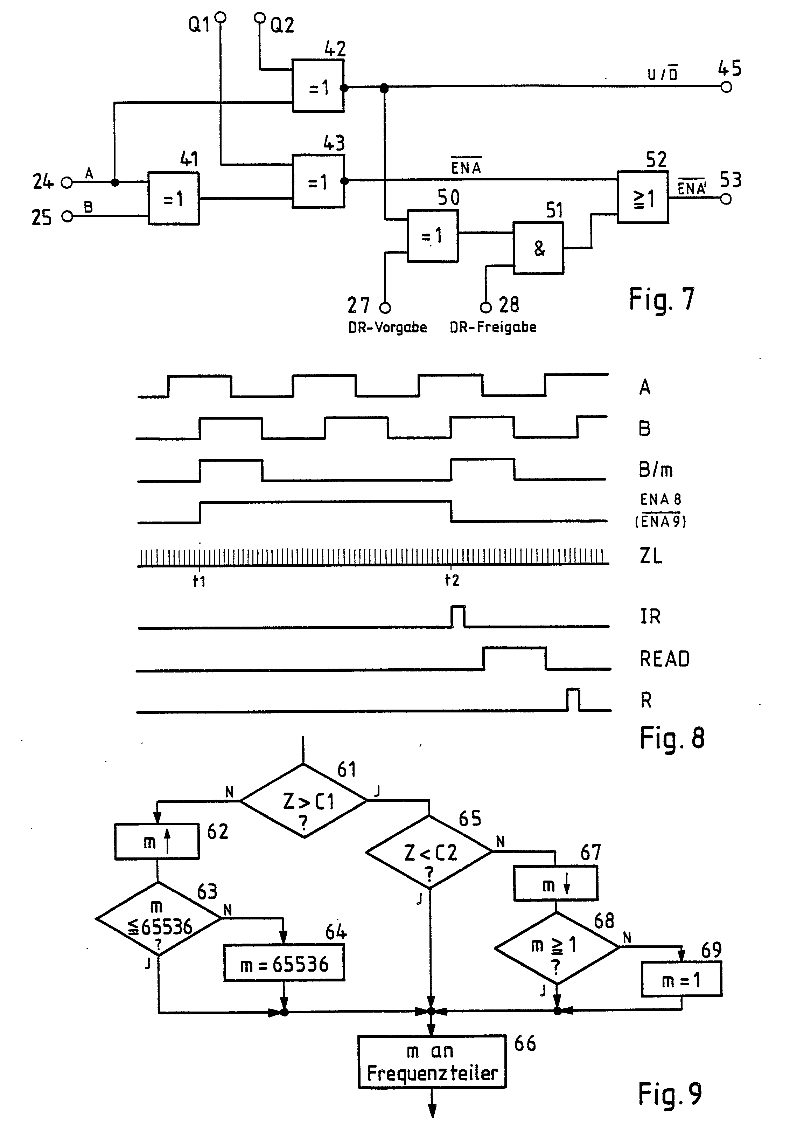

Da zum Einlesen des Zählerstandes jeweils eine Programmunterbrechung ausgelöst wird, werden dadurch andere Programmabläufe im Rechner gestört. Um diese Störungen nicht zu häufig auftreten zu lassen, wird bei höheren Drehzahlen die Frequenz der Tachosignale A und B - wie bereits beschrieben - geteilt.Einzelheiten hierzu werden unten im Zusammenhang mit den Figuren 8 und 9 beschrieben. Der Datenbus und der Rechner sind stark vereinfacht dargestellt, da geeignete Schaltungen und Bausteine hinreichend bekannt sind.

Zur Erfassung der Position werden die Tachosignale A und B und der Impuls 0 einer Zählerschaltung 12 zugeführt. Außerdem ist vorgesehen, daß der Impuls 0 eine Programmunterbrechung auslöst. Durch den Impuls 0 wird die Zählerschaltung rückgesetzt, so daß der Zählerstand die Position bzw. den Drehwinkel bezogen auf eine Anfangsstellung angibt. Dieser Wert wird bei der Anordnung nach Fig. 1 als Ist-Position einem Vergleicher 13 zugeführt und dort mit einer Soll-Position, welche vorher vom Rechner in ein Register 14 eingeschrieben wurde, verglichen. Ist die Maschine bei der Soll-Position angelangt, so sind beide Werte gleich und der Vergleicher 13 löst eine Programmunterbrechung aus, worauf der Rechner die bei der Soll-Position vorgesehenen Maßnahmen veranlaßt. Unmittelbar danach kann über das Register 14 eine neue Soll-Position eingegeben werden. Bis die Maschine diese neue Soll-Position erreicht, ist im Rechner keine laufende Erfassung der Position der Maschine erforderlich.

Zur Erhöhung der Auflösung bei der Positionsermittlung können der Zählerschaltung Zusatzimpulse von einem Zusatzimpulsgenerator 15 zugeführt werden, deren Frequenz einem Vielfachen der Frequenz der Tachosignale entspricht. Dazu wird der Oszillator 15 vom Rechner 3 aufgrund der Frequenzmessung mit Hilfe der Schaltungen 7 bis 11 gesteuert. Die Zählung der Zusatzimpulse ergibt die niederwertigen Stellen der dem Vergleicher 13 zugeführten Ist-Position. Bedingt durch die Trägheit der Maschine, ändert sich die Frequenz der Tachosignale nicht allzu schnell, so daß die Frequenzmessung und damit die Steuerung des Oszillators 15 für die nachfolgenden Perioden des Tachosignals mit ausreichender Genauigkeit erfolgen.

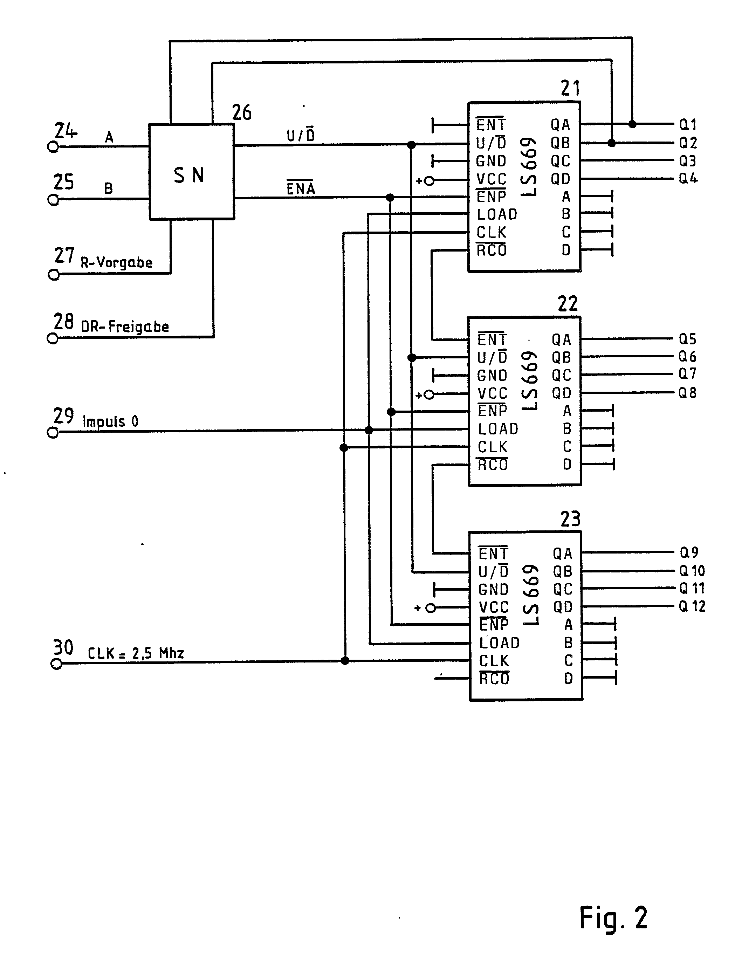

Fig. 2 zeigt ein Ausführungsbeispiel für die Zählerschaltung 12 (Fig. 1), bei welchem drei 4-Bit-Zähler vom Typ LS 669 vorgesehen sind. Übertragsausgänge der Zähler 21 und 22 sind mit Eingängen der Zähler 22 und 23 verbunden, so daß sich insgesamt ein 12-Bit-Zähler ergibt. Die Tachosignale A und B werden über Eingänge 24, 25 einem Schaltnetz 26 zugeführt, wo durch logische Verknüpfung mit den beiden niederwertigen Stellen Q1 und Q2 des Zählerstandes ein Aufwärts/Abwärtssignal U/$\overline{D}$ und ein Zählerfreigabesignal $\overline{ENA}$ abgeleitet werden. Außerdem werden dem Schaltnetz 26 über Eingänge 27, 28 die Signale DR-Vorgabe und DR-Freigabe zugeleitet. Das Signal DR-Vorgabe bezeichnet die Drehrichtung der Maschine. Das Signal DR-Freigabe besagt, ob die Drehzahl der Maschine über oder unterhalb einer Drehzahl ist, bei welcher eine Richtungsänderung erfolgen kann. Ein weiterer Eingang 29 ist für den Impuls 0 vorgesehen, der den LOAD-Eingang steuert und somit die Zähler rücksetzt, da die Dateneingänge A bis D auf Massepotential liegen. Schließlich weist die Zählerschaltung 12 einen Eingang 30 für ein Taktsignal CLK auf.

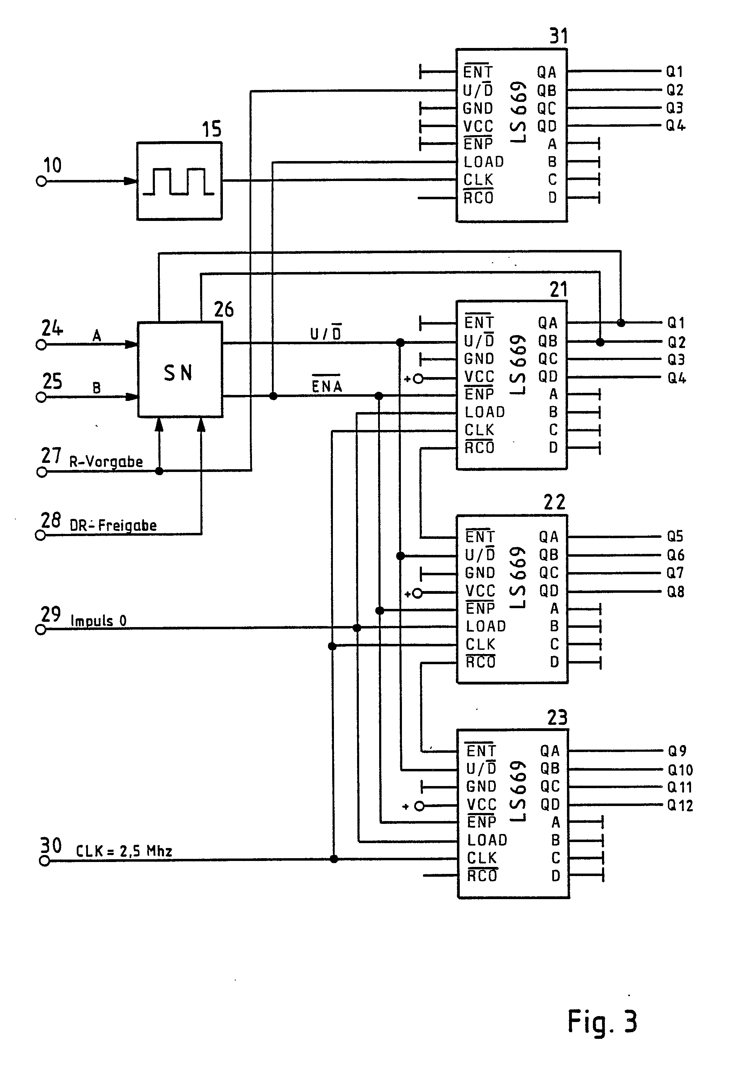

Wie bereits im Zusammenhang mit Fig. 1 erläutert, kann die Auflösung bei der Ermittlung der Position dadurch erhöht werden, daß mit Hilfe eines Oszillators 15 weitere Impulse erzeugt werden, deren Frequenz ein Vielfaches der Frequenz der Taktsignale beträgt. Bei dem in Fig. 3 dargestellten Ausführungsbeispiel erzeugt der Oszillator 15 Impulse mit 64-facher Tachofrequenz, die einem weiteren Zähler 31 vom Typ LS 669 zugeführt werden. Die Zählrichtung des weiteren Zählers 31 wird vom Signal DR-Vorgabe gesteuert. Damit wird der Zählerstand auf 16 Stellen (Q1' bis Q4', Q1 bis Q12) erweitert und die Auflösung auf das 16-fache erhöht, da durch die Auswertung beider Flanken der Tachosignale A und B bereits eine vierfache Zählfrequenz erzielt wird. Die Winkelauflösung beträgt bei einer Teilung von 1024 pro Vollkreis demnach 360/4096 = 0,0879 Grad ohne den weiteren Zähler 31 und 360/(4096·16) = 0,0055 Grad mit dem weiteren Zähler 31.

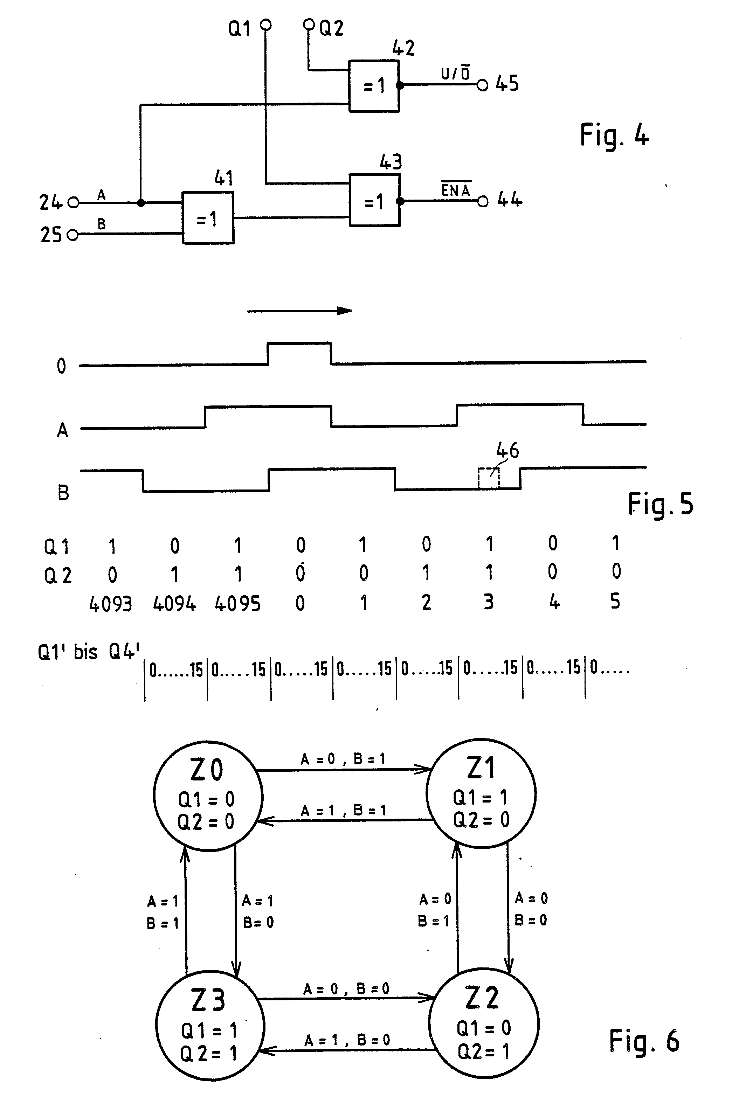

Fig. 4 zeigt ein Ausführungsbeispiel für das Schaltnetz 26, bei welchem die Signale DR-Freigabe und DR-Vorgabe nicht berücksichtigt werden. Das Schaltnetz umfaßt eine Antivalenz-Schaltung 41 sowie zwei Äquivalenz-Schaltungen 42, 43. Die Tachosignale A, B werden über die Eingänge 24, 25 beiden Eingängen der Antivalenz-Schaltung 41 zugeführt. Der Ausgang der Antivalenzschaltung 41 ist mit einem Eingang der Äquivalenz-Schaltung 43 verbunden, an deren anderem Eingang das geringstwertige Bit (LSB) Q1 anliegt. Am Ausgang 44 kann das Freigabesignal $\overline{ENA}$ für den Zähler entnommen werden. Zur Gewinnung eines Aufwärts/Abwärtssignals U/$\overline{D}$ werden das Tachosignal A sowie die zweitgeringstwertige Stelle Q2 des Zählerstandes der Äquivalenz-Schaltung 42 zugeführt, an deren Ausgang 45 das Signal U/$\overline{D}$ entnommen werden kann.

Die Funktion des Schaltnetzes nach Fig. 4 in Verbindung mit dem Zähler nach Fig. 2 wird im folgenden anhand von Fig. 5 näher erläutert. Fig. 5 zeigt Zeitdiagramme der Signale O, A und B für eine vorgegebene Drehrichtung, beispielsweise für Rechtslauf. Außerdem sind in Fig. 5 Werte von Q1 und Q2 des Zählers 21 und der gesamte Zählerstand Q1 bis Q12 angegeben. Schließlich ist der Zählerstand Q1' bis Q4' (Fig. 3) angedeutet.

Das Signal 0 tritt einmal während jeder Umdrehung auf, während die Tachosignale A und B entsprechend der Teilung des Inkrementalgebers häufiger auftreten - beispielsweise 1024 mal pro Umdrehung. Die Tachosignale A und B sind um 90° gegeneinander phasenverschoben. Durch den Impuls 0 wird der Zähler rückgesetzt, so daß der Zählerstand 0 wird und damit auch die beiden niederwertigen Stellen Q1 und Q2 den Wert 0 annehmen. Nach der ersten darauffolgenden Flanke des Tachosignals A werden A und B verschieden groß, so daß am Ausgang der Antivalenz-Schaltung 41 der Wert 1 liegt. Durch Verknüpfung mit Q1 = 0 in der Äquivalenz-Schaltung 43 wird der Ausgang 44 ebenfalls zu 0, was eine Freigabe des Zählers bewirkt. Da zu diesem Zeitpunkt Q2 = 0 ist und A = 0 wird, wird U/$\overline{D}$ = 1, was ein Inkrementieren des Zählers (Aufwärtszählen) bewirkt.

Durch die Inkrementierung des Zählers wird Q1 = 1, was wiederum bewirkt, daß bei der folgenden Flanke des Tachosignals B die Gleichheit der Tachosignale A und B zu $\overline{ENA}$ = 0 führt, so daß eine weitere Inkrementierung des Zählers erfolgt.

Zu Beginn der darauffolgenden Viertelperiode der Tachosignale springt das Signal A auf 1, da jedoch Q2 ebenfalls = 1 ist, wird U/$\overline{D}$ = 1. Da ferner A und B verschieden, Q1 jedoch = 0 ist, ergibt sich $\overline{ENA}$ = 0, so daß der Zähler abermals inkrementiert wird.

Zur weiteren Erläuterung der Funktion des Schaltnetzes gemäß Fig. 4 in Verbindung mit der Zählerschaltung, insbesondere mit dem Zähler 21 (Fig. 2) wird im folgenden auf den Automatengraphen gemäß Fig. 6 Bezug genommen. Danach kann das Schaltnetz 26 einschließlich der beiden niederwertigen Stellen des Zählers 21 die Zustände Z0, Z1, Z2 und Z3 einnehmen. Die bei diesen Zuständen an den Ausgängen Q1 und Q2 anstehenden Werte sind in den die Zustände darstellenden Kreisen angegeben. Ein Übergang von einem Zustand in einen anderen kann nur im Sinne eines Aufwärts- bzw. Abwärtszählen erfolgen, was in Fig. 6 durch Pfeile zwischen den Kreisen angedeutet ist. Dabei bedeuten die Zahlen an den Pfeilen die für den jeweiligen Übergang erforderlichen Werte der Tachosignale A und B. So wird beispielsweise ein Übergang vom Zustand Z0 zum Zustand Z1 durch A = 0 und B = 1 verursacht. Wird danach B = 0, so geht das Schaltnetz in den Zustand 2 über.

Am Beispiel eines Störimpulses 46 (Fig. 5) wird die Filterwirkung des Schaltnetzes erläutert. Vor dem Störimpuls befindet sich das Schaltnetz im Zustand Z3. Dadurch, daß während des Störimpulses 46 das Tachosignal B den Wert 1 annimmt, erfolgt ein Weiterschalten in den Zustand Z0, da auch das Tachosignal A = 1 ist. Am Ende des Störimpulses wird jedoch wieder B = 0, so daß das Schaltnetz in den Zustand Z3 zurückgesetzt wird. Der Zähler wird also durch den Störimpuls 46 inkrementiert, nach dem Störimpuls jedoch wieder dekrementiert, so daß keine Verfälschung des Zählergebnisses erfolgt.

Das in Fig. 4 dargestellte Schaltnetz bewirkt also, daß in einem beliebigen Zustand nur die jeweils benachbarten Zustände zugelassen werden. Auf den Zählerstand 0 kann also nur einer der Zählerstände 1 oder 4095 folgen. Eine weitere Erhöhung der Betriebssicherheit wird durch die Vorgabe der Drehrichtung über den Rechner 3 (Fig. 1) gewonnen. Dabei wird eine durch die Tachosignale A und B angezeigte Änderung der Drehrichtung als Fehler erkannt, wenn dieses im Widerspruch zu dem vom Rechner zugeführten Signal DR-Vorgabe steht. Diese zusätzliche Prüfung kann allerdings bei Stillstand oder kleinen Drehzahlen zu Fehlern führen und wird daher abgeschaltet, wenn aufgrund geringer Drehzahlen ein Drehrichtungswechsel möglich ist. Es wird daher vom Rechner ein weiteres Signal DR-Freigabe zugeführt, das oberhalb einer vorgegebenen Drehzahl den Wert 1 annimmt.

Das Schaltnetz gemäß Fig. 7 enthält zusätzlich zu den bereits im Zusammenhang mit Fig. 4 erläuterten Teilen eine Antivalenz-Schaltung 50, eine Und-Schaltung 51 und eine Oder-Schaltung 52. Das Ausgangssignal $\overline{ENA}$ der Äquivalenz-Schaltung 43, das bei dem Schaltnetz nach Fig. 4 den Zähler sperrt ($\overline{ENA}$ = 1) oder freigibt ($\overline{ENA}$ = 0), wird bei dem Schaltnetz nach Fig. 7 nochmals durch eine Oder-Schaltung 52 gefiltert, deren Ausgangssignal $\overline{ENA}'$ über den Ausgang 53 dem Zähler zugeführt wird. Liegt am unteren Eingang der Oder-Schaltung 52 der Wert 0, so wird $\overline{ENA}'$ = $\overline{ENA}$, so daß das Schaltnetz nach Fig. 6 wie das Schaltnetz nach Fig. 4 arbeitet. Bei einer 1 am unteren Eingang wird jedoch der Ausgang 53 unabhängig vom Wert von $\overline{ENA}$ auf 1 gesetzt, was ein Sperren des Zählers bewirkt.

Dieses Sperren des Zählers kann jedoch nur erfolgen, wenn beiden Eingängen der Und-Schaltung 51 der Wert 1 zugeführt wird. Dieses ist der Fall, wenn sowohl das Signal DR-Freigabe den Wert 1 aufweist, als auch die beiden unabhängig voneinander gewonnenen die Drehrichtung kennzeichnenden Signale U/$\overline{D}$ und DR-Vorgabe verschieden voneinander sind.

Fig. 8 stellt verschiedene Signale dar, welche bei der Messung der Drehzahl mit Hilfe der Zähler 8, 9 sowie der dazugehörigen Schaltungen von Bedeutung sind. Von den Tachosignalen A und B wird mit Hilfe des Umschalters 7 bei dem in Fig. 8 dargestellten Betriebszustand das Tachosignal B weitergeleitet. Der Frequenzteiler 17, der über den Datenbus 10 auf Teilerverhältnisse von 1:1 bis 1:65536 (m = 1 bis m = 65536) eingestellt werden kann, teilt bei der Darstellung nach Fig. 8 die Frequenz des Tachosignals B durch 2, wodurch die in Zeile B/m dargestellten Impulse entstehen. Um die Zähler 8, 9 abwechselnd während jeweils einer Periodendauer des Signals B/m betreiben zu können, wird ein mäanderförmiges Signal ENA8 bzw. $\overline{ENA}$9 abgeleitet, was den entsprechenden Steuereingängen der Zähler 8, 9 zugeführt wird. Die weiteren Darstellungen beziehen sich auf den Zähler 8.

Die vom Oszillator 11 erzeugten Zählimpulse ZI sind in Fig. 8 lediglich angedeutet und werden zwischen den Zeitpunkten t1 und t2 gezählt. Bei t2 wird der Zähler 8 angehalten und gibt einen Impuls IR zur Programmunterbrechung an den Rechner 3. Dieser liest daraufhin über den Datenbus 10 den Zählerstand, was in Fig. 8 durch ein Signal READ angedeutet ist. Danach kann mit Hilfe eines Rücksetzimpulses R der Zähler wieder auf 0 gesetzt werden und steht bei der übernächsten Periode des Signals B/m wieder zum Zählen zur Verfügung. Inzwischen werden die Zählimpulse mit Hilfe des Zählers 9 gezählt.

Anhand des in Fig. 9 dargestellten Programmausschnitts wird die Steuerung des Frequenzteilers 17 erläutert. Im Programmschritt 61 wird zunächst abgefragt, ob der Zählerstand Z des Zählers 8 bzw. 9 größer als ein unterer Grenzwert C1 ist. Ist dieses nicht der Fall, so wird m bei 62 erhöht. Danach wird abgefragt, ob m kleiner oder gleich 65536 ist. Ist dieses der Fall, so wird m auf dem bei 62 erhöhten Wert belassen und der weiteren Drehzahlmessung zugrundegelegt. Anderenfalls wird m auf 65536 gesetzt.

Ist im Programmteil 61 festgestellt worden, daß der Zählerstand Z größer als C1 ist, wird bei 65 geprüft, ob der Zählerstand Z kleiner als ein oberer Grenzwert C2 ist. Ist dieses der Fall, so wird m bei 66 unverändert an den Frequenzteiler ausgegeben. Ist der Zählerstand jedoch nicht kleiner als C2, wird bei 67 m reduziert. Bei 68 wird entschieden, ob m dabei kleiner als 1 geworden ist, worauf bei 69 m = 1 gesetzt wird. Bei 66 wird dann der reduzierte Wert von m bzw. m = 1 dem Frequenzteiler zugeführt.

## Ansprüche

1. Verfahren zur Messung der Drehzahl einer Maschine, insbesondere einer Druckmaschine, bei der ein Inkrementalgeber Tachoimpulse erzeugt, dadurch gekennzeichnet, daß während eines von den Tachoimpulsen abgeleiteten Zeitabschnitts Zählimpulse gezählt werden und daß am Ende des Zeitabschnitts bei einem Rechner eine Programmunterbrechung ausgelöst und der Zählerstand vom Rechner gelesen wird.

2. Verfahren nach Anspruch 1, dadurch gekennzeichnet, daß der Zeitabschnitt der Periodendauer oder einem Vielfachen der Periodendauer der Tachoimpulse entspricht.

3. Verfahren nach Anspruch 2, dadurch gekennzeichnet, daß das Vielfache in Abhängigkeit von der Drehzahl mit zunehmender Drehzahl ansteigend vorgegeben wird.

4. Verfahren nach einem der vorhergehenden Ansprüche, dadurch gekennzeichnet, daß die Frequenz der Zählimpulse veränderbar ist.

5. Anordnung zur Durchführung des erfindungsgemäßen Verfahrens, dadurch gekennzeichnet, daß die Tachoimpulse über einen steuerbaren Frequenzteiler einer Zählerschaltung zuführbar sind, daß die Zählerschaltung mit einer Schaltung zur Erzeugung von Zählimpulsen verbunden ist, und daß Ausgänge der Zählerschaltung mit Eingängen eines Rechners verbunden sind.

6. Anordnung nach Anspruch 5, dadurch gekennzeichnet, daß die Zählerschaltung zwei abwechselnd ansteuerbare Zähler umfaßt.

7. Anordnung nach Anspruch 5, dadurch gekennzeichnet, daß zwei gegeneinander phasenverschobene Tachosignale, welche Tachoimpulse beinhalten, einem dem steuerbaren Frequenzteiler vorgeschalteten Umschalter zuführbar sind, der von einer Überwachungseinrichtung für die Tachosignale steuerbar ist.

8. Anordnung nach Anspruch 5, dadurch gekennzeichnet, daß die Schaltung zur Erzeugung der Zählimpulse bezüglich der Frequenz der Zählimpulse über Dateneingänge steuerbar ist.

Fig. 1

Fig. 2

Fig. 3

Fig. 4

Fig. 5

| Q1 | 1 | 0 | 1 | 0 | 1 | 0 | 1 | 0 | 1 |
|----|---|---|---|---|---|---|---|---|---|
| Q2 | 0 | 1 | 1 | 0 | 0 | 1 | 1 | 0 | 0 |
| | 4093 | 4094 | 4095 | 0 | 1 | 2 | 3 | 4 | 5 |

Q1' bis Q4'

$|0\ldots\ldots15|0\ldots\ldots15|0\ldots\ldots15|0\ldots\ldots15|0\ldots\ldots15|0\ldots\ldots15|0\ldots\ldots15|0\ldots\ldots|$

Fig. 6

Q1 ○   ○ Q2

42
=1        U/D̄   ○ 45

41        43
=1        =1    ENA̅

24 ○ A
25 ○ B            52
                  ≥1   ENA̅'  ○ 53

50        51
=1        &

27 ○              28 ○
DR-Vorgabe   DR-Freigabe

**Fig. 7**

A

B

B/m

ENA 8
(ENA̅ 9)

ZL
t1                    t2

IR

READ

R

**Fig. 8**

61
Z > C1
?
N          J

62
m ↑

65
Z < C2
?
N          J

67
m ↓

63
m
≦ 65536
?
J          N

64
m = 65536

68
m ≧ 1
?
N          J

69
m = 1

66
m an
Frequenzteiler

**Fig. 9**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | PROCEEDINGS IECON '85, San Francisco, California, 18.-22. November 1985, Band 2, Seiten 697-702, IEEE, New York, US; K.M. AL-AUBIDY: "Microprocessor - based new measurement technique of angular velocity for real time applications" * Seite 698, Spalte 1, Zeilen 1-13; Seite 698, Spalte 2, Zeile 21 - Seite 699, Spalte 1, Zeile 7; Figuren 1,3 * | 1,4,8 | G 01 P    3/489 G 01 R   23/02 |
| A | Idem --- | 5 | |
| X | IEEE 1981 IECI PROCEEDINGS, 1981, "Applications of mini and microcomputers", San Francisco, California, 9.-12. November 1981, Seiten 381-386, IEEE, New York, US; T. OMAE et al.: "A microprocessor-controlled high-accuracy wide-range speed regulator for motor drives" * Seite 382, Spalte 2, Zeilen 28-41; Figur 4 * | 1,2 | |
| Y | Idem --- | 4,5,8 | RECHERCHIERTE SACHGEBIETE (Int. Cl.4) G 01 P G 01 R |
| Y | TECHNISCHES MESSEN, Band 8, Nr. 3, März 1981, Seiten 83-88, München, DE; J. DÜNNWALD: "Digitale Drehzahlerfassung elektrischer Antriebe mit Mikrorechner" * Seite 87, Spalte 1, Zeile 18 - Spalte 2, Zeile 2; Figur 5 * | 4,8 | |
| A | Idem --- | 1,2,5 | |

-/-

Der vorliegende Recherchenbericht wurde für alle Patentansprüche erstellt

| Recherchenort | Abschlußdatum der Recherche | Prüfer |
|---|---|---|
| DEN HAAG | 08-09-1989 | HANSEN P. |

EPO FORM 1503 03.82 (P0403)

Europäisches
Patentamt

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | ELEKTROTECHNISCHE ZEITSCHRIFT, E.T.Z., Band 27, Nr. 75, 25. Juli 1975, Seiten 405-407, Berlin, DE; D. HOFFMANN et al.: "Lückenlose Pulsdauermessung zum Messen von Winkelgeschwindigkeiten" * Seite 405, Spalte 1, Zeilen 45-51; Seite 405, Spalte 2, Zeile 6 - Spalte 3, Zeile 5; Seite 406, Spalte 2, Zeilen 1-4; Figuren 2,4 * | 5 | |
| A | Idem --- | 4,6 | |
| A | DE-A-3 234 575 (OHARA) * Seite 12, Zeilen 9-12; Figuren 5,6 * ----- | 1,5,6 | |
| | | | RECHERCHIERTE SACHGEBIETE (Int. Cl.4) |

Der vorliegende Recherchenbericht wurde für alle Patentansprüche erstellt

| Recherchenort | Abschlußdatum der Recherche | Prüfer |
|---|---|---|
| DEN HAAG | 08-09-1989 | HANSEN P. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
......................................................
& : Mitglied der gleichen Patentfamilie, übereinstimmendes Dokument

EPO FORM 1503 03.82 (P0403)